# EUROPEAN PATENT SPECIFICATION

(11) **EP 1 741 124 B1**
(45) Date of publication and mention of the grant of the patent: **22.12.2010**
(21) Application number: 05756491.6
(22) Date of filing: 29.04.2005
(51) Int. Cl.: H01J 37/32

(54) **SEGMENTED BAFFLE PLATE ASSEMBLY FOR A PLASMA PROCESSING SYSTEM**
SEGMENTIERTE PRALLPLATTE FÜR EIN PLASMAVERARBEITUNGSSYSTEM
ENSEMBLE CHICANE EN PLUSIEURS PARTIES DESTINE A UN SYSTEME DE TRAITEMENT AU PLASMA

(30) Priority: 30.04.2004 US 836516
(43) Date of publication of application: 10.01.2007
(73) Proprietor: Axcelis Technologies, Inc., Beverly, MA 01915 (US)
(72) Inventor: FERRIS, David, Rockville, Maryland 20850 (US); SRIVASTAVA, Aseem, Germantown, Maryland 20874 (US); TUN, Maw, Rockville, Maryland 20853 (US)
(74) Representative: Treeby, Philip David William
(86) International application number: PCT/US2005/014588
(87) International publication number: WO 2005/112072

(56) References cited:
- EP-A- 0 702 392
- WO-A-03/007326
- US-A1- 2003 143 328
- US-A1- 2004 056 602

## Description

### BACKGROUND

In the manufacture of integrated circuits, photolithography techniques are used to form integrated circuit patterns on a substrate, such a silicon wafer. Typically, the substrate is coated with a photoresist, portions of which are exposed to ultraviolet (UV) radiation through a mask to image a desired circuit pattern on the photoresist. The portions of the photoresist left unexposed to the UV radiation are removed by a processing solution, leaving only the exposed portions on the substrate. These remaining exposed portions may be baked during a photostabilization process to enable the photoresist to withstand subsequent processing.

After such processing, in which the integrated circuit components are formed, it is generally necessary to remove the baked photoresist from the wafer. In addition, residue that has been introduced on the substrate surface through processes such as etching must be removed. Typically, the photoresist is "ashed" or "burned" and the ashed or burned photoresist, along with the residue, is "stripped" or "cleaned" from the surface of the substrate.

One manner of removing photoresist and residues is by rapidly heating the photoresist-covered substrate in a vacuum chamber to a preset temperature by infrared radiation, and directing microwave-energized or radio frequency (RF) energized reactive gases (i.e., a plasma) toward the heated substrate surface. In the resulting process, the reactive plasma reacts with the photoresist to ash it for subsequent removal from the wafer.

It is important that the ashing process occur at substantially the same rate across the surface of the wafer. To insure such uniform ashing of the photoresist, the process conditions should be precisely controlled. Process conditions that must be so controlled include the temperature of the process chamber and the temperature of the wafer.

Known gas distribution or baffle plate assemblies for uniformly directing energized plasma onto a wafer surface generally comprise one or two parallel apertured plates that are typically made of quartz, or in the case of two parallel plates, an upper quartz plate and a lower metal plate. Quartz is generally chosen for its ability to withstand high process temperatures. However, the use of quartz makes acceptable wafer and process temperature uniformity difficult to obtain. The temperature non-uniformities may be caused by the large temperature gradients that can develop across the surface of a quartz plate due to its poor thermal conductivity characteristics. In addition, undesirable infrared (IR) wavelength absorption characteristics of quartz add to the thermal energy absorbed by the baffle plate. As a result, process uniformity and system throughput are adversely affected.

For plasma tools requiring the use of fluorine chemistries, the upper quartz plate may be further coated with a sapphire coating. The presence of the sapphire coating prevents etching of the plate from exposure to the reactive fluorine species. A solid, single plate could be fabricated entirely from sapphire; however, this is generally considered by those in the art to be cost prohibitive. The sapphire coated quartz plate may additionally include a central impingement disc formed of a ceramic material to deflect the incoming plasma jet into the process chamber plenum and also reduces the high temperature exposure to the coated sapphire material.

Several problems of these types of baffle plate assemblies are known to exist. For example, with regard to the sapphire coated plates, the sapphire coating tends to flake off after protracted use, which is believed to be due to unequal and non-conformal sidewall coating of the apertures disposed therein relative to the top and bottom surfaces of the plate. Still further, periodic replacement of the sapphire coated plate and/or ceramic disc leads to higher end costs since the sapphire coating adds significant cost to the quartz plate.

Solid ceramic baffle plates can be used to resolve many of the problems facing the prior art. However, subjecting solid ceramic plates of the size utilized in plasma process chambers to a thermal gradient during operation of the plasma can result in catastrophic failure. At a baffle plate radius greater than about 5 inches (1 inch = 2.54 cm), the so-called "hoop" stresses in the plate can exceed the capability of the ceramic material causing the plate to crack. Cracking of the plate deleteriously results in particle generation as well as contaminates the process chamber, thereby requiring expensive downtime, repair, and replacement.

Accordingly, there is a need in the art for an improved baffle plate assembly that maintains plasma uniformity and can withstand the various conditions utilized during the plasma process, e.g. withstands thermal gradient related stresses, and/or is economical viable, and/or is compatible with fluorine chemistries, and/or the like.
EP 0 702 392 discloses a gas injection apparatus for injecting gases into a plasma reactor vacuum chamber having a chamber housing (10), a pedestal holding a workpiece to be processed, means for applying RF energy into the chamber, the gas injection apparatus having a gas supply containing an etchant species in a gas, an opening in the chamber housing, a gas feed line (15), from the supply to the opening in the chamber housing, and gas distribution apparatus near the opening in the chamber housing, the gas feed apparatus having at least one slit nozzle (25) facing the interior of the chamber. In a preferred embodiment, the gas distribution apparatus includes a disk member (20a) surrounded by at least one annular member (35a) with a gap (25) therebetween comprising the slit nozzle, the disk member and annular member blocking gas flow through the opening in the chamber housing.
WO 03/007326 discloses a method for creating and transporting low-energy ions for use in plasma processing of a semiconductor wafer. In an exemplary embodiment of the invention, the method includes generating plasma from a gas species to produce a plasma exhaust. The plasma exhaust is then introduced into a processing chamber containing the wafer. The ion content of the plasma exhaust is enhanced by activating a supplemental ion source as the plasma is introduced into the processing chamber, thereby creating a primary plasma discharge therein. Then, the primary plasma discharge is directed into a baffle plate assembly, thereby creating a secondary plasma discharge exiting the baffle plate assembly. The strength of an electric field exerted on ions contained in the secondary plasma discharge is reduced. In so doing, the reduced strength of the electric field causes the ions to bombard the wafer at an energy insufficient to cause damage to semiconductor devices formed on the wafer.
US 2003/0143328 discloses an apparatus and method of plasma assisted deposition by generation of a plasma adjacent a processing region.
US 2004/0056602 discloses a plasma reactor for processing a semiconductor wafer including a side wall and an overhead ceiling defining a chamber, a workpiece support cathode within the chamber having a working surface facing the ceiling for supporting a semiconductor workpiece, process gas inlets for introducing a process gas into the chamber and an RF bias power generator having a bias power frequency. There is a bias power feed point at the working surface and an RF conductor is connected between the RF bias power generator and the bias power feed point at the working surface. A dielectric sleeve surrounds a portion of the RF conductor, the sleeve having an axial length along the RF conductor, a dielectric constant and an axial location along the RF conductor, the length, dielectric constant and location of the sleeve being such that the sleeve provides a reactance that enhances plasma ion density uniformity over the working surface. In accordance with a further aspect, the reactor can include an annular RF coupling ring having an inner diameter corresponding generally to a periphery of the workpiece, the RF coupling ring extending a sufficient portion of a distance between the working surface and the overhead electrode to enhance plasma ion density near a periphery of the workpiece.

### BRIEF SUMMARY

According to the present invention there is provided a ceramic baffle plate assembly for distributing plasma into a process chamber containing a semiconductor wafer to be processed, the ceramic baffle plate assembly comprising: a generally planar multi-piece baffle plate that can be spaced apart from and fixedly positioned above the semiconductor wafer to be processed, wherein the generally planar multi-piece baffle plate comprises at least one annular shaped ring portion defining a central through hole opening and an insert portion dimensioned to sit within the central through hole opening, wherein the annular shaped ring portion and the insert portion are configured so as to form a single layer of the generally planar multi-piece baffle plate, and being characterised in that a gap of less than 0.25mm (0.010 inches) is provided between the insert portion and the annular shaped ring portion.

A plasma processing chamber for processing a semiconductor wafer comprises a wafer processing cavity into which a wafer may be inserted for processing, the wafer processing cavity defined in part by walls including a top wall; and a baffle plate assembly located adjacent said wafer processing cavity for distributing energized gas thereinto, said baffle plate assembly comprising a ceramic baffle plate assembly as described above ([0010]) fixedly positioned above a generally planar lower baffle plate.

A downstream plasma treatment device for treating a substrate, comprises, in combination a gas source; a plasma generating component in fluid communication with the gas source, the plasma generating component comprising a plasma tube and a plasma generator coupled to the plasma tube for generating a plasma within the plasma tube from the gas source; and a plasma processing chamber as described above ([0011]) and in fluid communication with the plasma tube.
A method for preventing cracking of a ceramic baffle plate having a radius greater than 100mm (4 inches) during a plasma mediated process, wherein the plasma mediated process subjects the ceramic baffle plate to a thermal temperature gradient across the plate, the method comprising: forming the ceramic baffle plate into at least two pieces wherein the at least two pieces comprise at least one annular shaped ring portion having a central through hole opening and an insert portion dimensioned to sit within the central through hole opening, such that the annular shaped ring portion and the insert portion form a single layer of the ceramic baffle plate, and such that a gap formed between the insert portion and the annular shaped ring portion is less than 0.25mm (0.010 inches); and exposing the at least two pieces of the ceramic baffle plate to plasma formed during the plasma mediated process,

The above described and other features are exemplified by the following figures and detailed description of embodiments of the present invention.

### BRIEF DESCRIPTION OF THE DRAWINGS

Referring now to the figures, which are exemplary embodiments and wherein like elements are numbered alike:

Figure 1 is a sectional view of an exemplary photoresist asher into which is incorporated a first embodiment of a baffle plate assembly constructed according to the present disclosure;

Figure 2 graphically illustrates tangential stress in a ceramic baffle plate at a given thermal gradient;

Figure 3 is an exploded perspective view of a single layered multi-piece baffle plate assembly;

Figure 4 is a cross sectional view of the single layered multi-piece baffle plate assembly taken along lines 4--4;

Figure 5 is a plan view of an exemplary insert portion for a single layered multi-piece baffle plate assembly; and

Figure 6 is a cross sectional view of the exemplary insert portion taken along lines 6--6.

### DETAILED DESCRIPTION

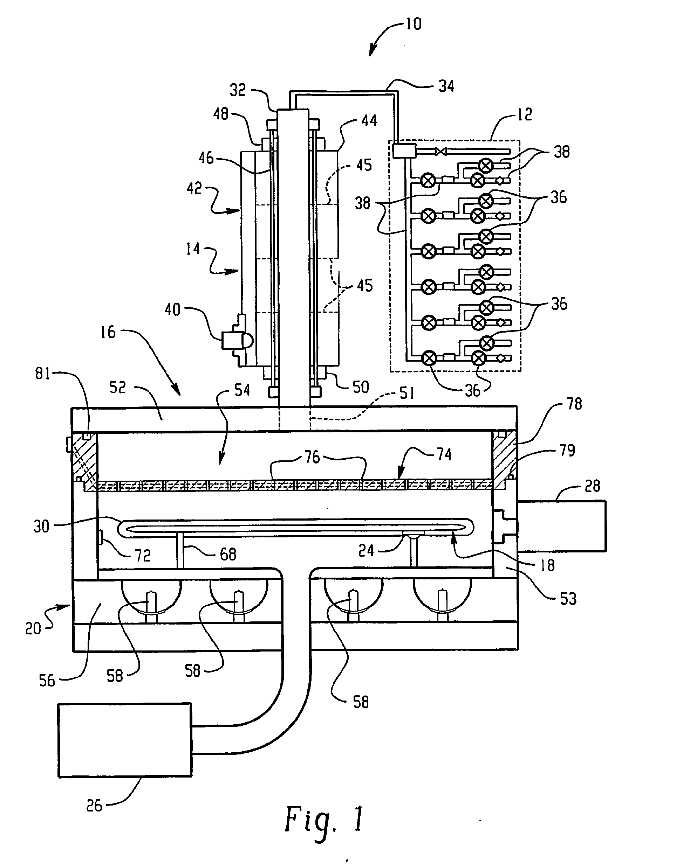

Referring now to the drawings, Figure 1 illustrates an exemplary photoresist asher 10, generally comprising a gas box 12, a microwave plasma generator assembly 14, a process chamber 16 defming an interior cavity in which is processed a semiconductor substrate such as a wafer 18, and a radiant heater assembly 20 for heating the wafer 18 situated at the bottom of the process chamber. A temperature probe 24, such as a thermocouple, is used to monitor the temperature of the wafer 18 during operation. A vacuum pump 26 is used to evacuate the process chamber 16 for processes requiring vacuum conditions.

An optional monochromator 28 is used to monitor the optical emission characteristics of gases within the chamber to aid in process endpoint determination. The wafer 18 is introduced into and removed from the process chamber 16 via an appropriate load lock mechanism (not shown) via entry/exit passageway 30. Alternately, the wafer 18 may be introduced directly into the process chamber 16 through the entry/exit passageway 30 if the tool is not equipped with a load lock. Although the present disclosure is shown and characterized as being implemented within a photoresist asher, it may also be used in other semiconductor manufacturing equipment, such as residue removal and strip processes. For example, downstream axial flow plasma apparatuses particularly suitable for modification in the present disclosure are plasma ashers, such as for example, those microwave plasma ashers available under the trade name RadiantStrip320 and commercially available from Axcelis Technologies Corporation. Portions of the microwave plasma asher are described in U.S. Pat. Nos. 5,498,308 and 4,341,592, and PCT International Application No. WO/97/37055. As will be discussed below, the disclosure is not intended to be limited to any particular plasma asher in this or in the following embodiments. For instance, the processing plasma can be formed using a parallel-plate, capacitively coupled plasma source, an inductively coupled plasma source, and any combination thereof, with and without DC magnet systems. Alternately, the processing plasma can be formed using electron cyclotron resonance. In yet another embodiment, the processing plasma is formed from the launching of a Helicon wave. In yet another embodiment, the processing plasma is formed from a propagating surface wave.

In operation, a desired mixture of gases is introduced into a plasma tube 32 from gas box 12 through an inlet conduit 34. The plasma tube 32 can be made of alumina (Al₂O₃) or sapphire to accommodate fluorine chemistries without etching, degradation, and/or other issues associated with fluorine chemistries. The gases forming the desired mixture are stored in separate supplies (not shown) and mixed in the gas box 12 by means of valves 36 and piping 38. One example of a desired gas mixture is nitrogen-forming gas (primarily nitrogen with a small percentage of hydrogen), and oxygen. A fluorine containing gas, such as carbon tetrafluoride (CF₄), may be added to the gas mixture to increase ashing rates for certain processes.

The desired gas mixture is energized by the microwave plasma generator assembly 14 to form a reactive plasma that will ash photoresist on the wafer 18 in the process chamber 16 when heated by the radiant heater assembly 20. A magnetron 40 generates microwave energy that is coupled to a waveguide 42. Microwave energy is fed from the waveguide through apertures (not shown) in microwave enclosure 44, which surrounds the plasma tube 32.

An outer quartz cooling tube 46 surrounds the plasma tube 32, slightly separated therefrom. Pressurized air is fed into the gap between the tubes 32 and 46 to effectively cool the tube 32 during operation. The microwave enclosure 44 can be segmented into sections shown by phantom lines 45. Segmentation of the enclosure 44 can provide uniform microwave power distribution across the length of the alumna or sapphire plasma tube, and protects it from overheating by preventing an unacceptably large thermal gradient from developing along its axial length when suitable input power is provided. Each segment of the enclosures 44 is separately fed with microwave energy that passes through the quartz tube 46 and the alumna or sapphire tube 32 passing therethrough.

The gas mixture within the plasma tube 32 is energized to create a plasma. Microwave traps 48 and 50 can be provided at the ends of the microwave enclosure 44 to prevent microwave leakage. Energized plasma (typically having a temperature of about 150° C) enters the process chamber 16 through an opening 51 in the top wall 52 thereof.

Positioned between the top wall 52 of the plasma chamber 16 and the wafer 18 being processed is a multi-piece baffle plate assembly 54. Although shown as a single layered multi-piece baffle plate assembly, it is contemplated that the multi-piece baffle plate may take the form of a dual- layered multi-piece baffle plate assembly comprising upper and lower baffle plates, wherein the upper baffle plate is formed of the multiple pieces in the manner described with respect to the single layered multi-piece baffle plate assembly. In either embodiment, the multi-piece baffle plate assemblies evenly distribute the reactive plasma across the surface of the wafer 18 being processed. Moreover, the multi-piece construction can minimize heat stresses during operation, which have been observed to cause catastrophic failure in ceramic type baffle plate assemblies having layers fabricated from a single piece of the ceramic material.

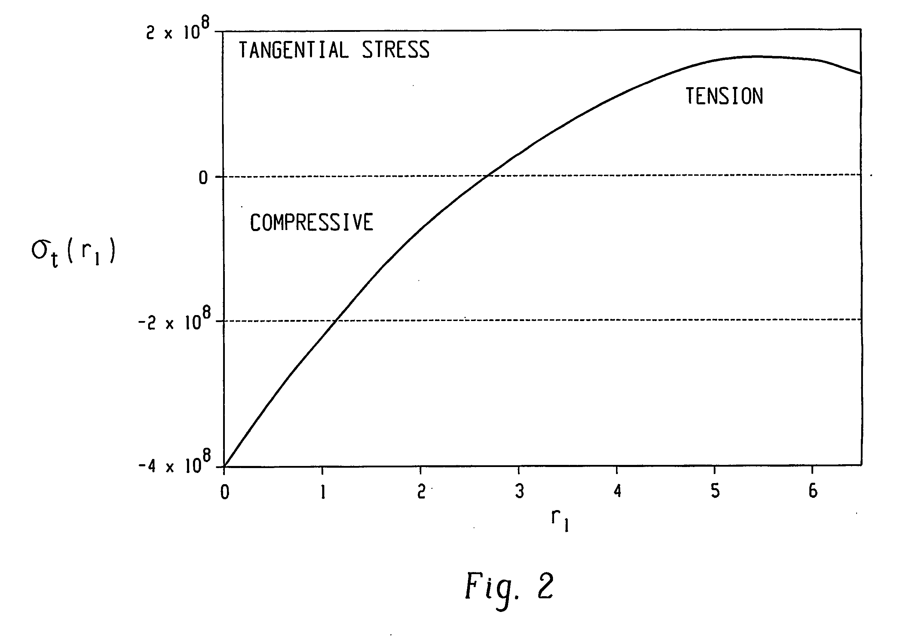

For example, as shown in Figure 2, exposing a ceramic (alumina) baffle plate assembly to a thermal gradient across the baffle plate can result in cracking of the plate during operation as a result of hoop stresses. Ceramic materials suitable for use as baffle plates are generally stronger in compression than tension. Because of this, hoop stresses caused by thermal gradients occurring in the plate during plasma processing can exceed the material strength. In this particular example, the tensile strength of the ceramic was about 1E8 MPa to about 2E8 MPa, which is the maximum shown for about a 4 to about a 5 inch plate radius. The use of multi-piece construction as disclosed herein, permits the use of materials such as ceramics for fabrication of the baffle plate(s) without causing premature cracking by preventing the hoop stresses from exceeding the material strength. As such, ceramic multi-piece baffle plate assemblies provide an inexpensive alternative to sapphire coated baffle plate assemblies and eliminate the problems associated with the use of sapphire coatings. The multi-piece ceramic baffle plate is especially desirable for processes including fluorine chemistries.

With reference back to Figure 1, in operation, the reactive plasma passes through the multi-piece baffle plate 54 and can be used to ash the photoresist and/or residues on the wafer 18. The radiant heater assembly 20 comprises a plurality of tungsten halogen lamps 58 residing in a reflector 56 that reflects and redirects the heat generated by the lamps toward the backside of the wafer 18 positioned within the process chamber 16 on quartz or ceramic pins 68. One or more temperature sensors 72, such as thermocouples, can be mounted on the interior of process chamber sidewall 53 to provide an indication of wall temperature.

The single layered multi-piece baffle plate assembly 54 comprises a generally planar gas distribution central portion 74, having apertures 76 therein, surrounded by a flange 78. The flange 78 surrounds the central portion and seats intermediate the process chamber sidewall 53 and top wall 52. Seals 79 and 81, respectively, provide airtight connections between the flange 78 and the sidewall 53, and between the flange 78 and the top wall 52. The seals 79 and 81 reside in grooves located in the flange 78. The flange 78 also provides mounting holes (not shown) for mounting to the top wall 52 and sidewall 53.

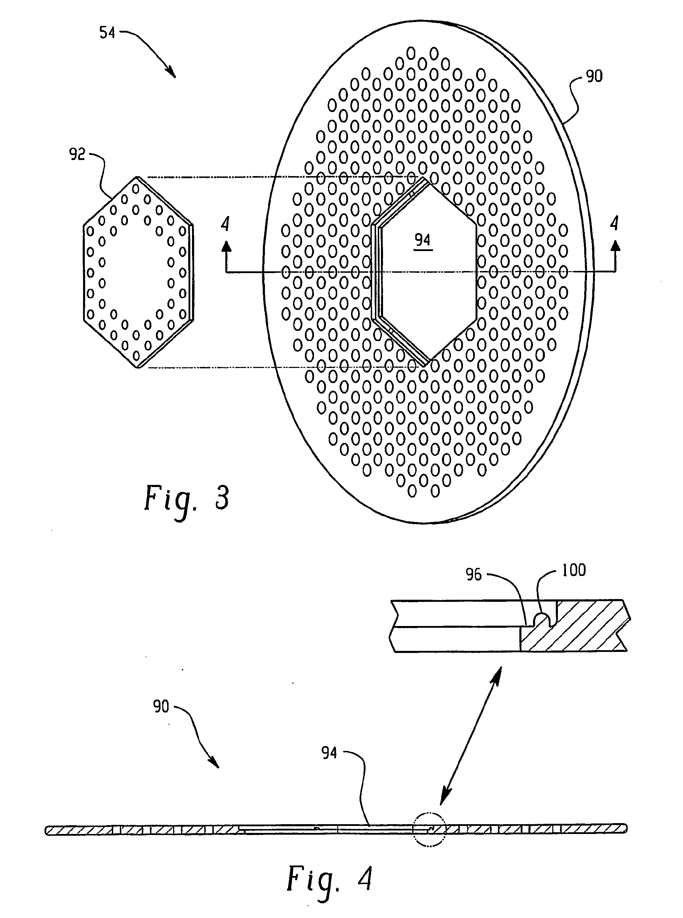

As shown more clearly in Figures 3-6, the illustrated single layered multi-piece baffle plate assembly 54 comprises a two-piece construction. However, although the figures illustrate a two-piece construction, greater than two pieces are contemplated and may actually be desired for certain applications. Moreover, it should be apparent to those skilled in the art that the shapes of the various pieces to form the baffle plate are not intended to be limited to any particular shape or aperture pattern. It has been found that the use of multiple pieces to form the baffle plate advantageously relieves the thermal stresses introduced during plasma operation, the design of which is virtually limitless as will be appreciated by those skilled in the art in view of this disclosure.

In Figure 3, there is illustrated an exploded perspective view of the multi-piece baffle plate assembly 54. The multi-piece baffle plate assembly 54 generally comprises a generally annular shaped ring 90 and an insert portion 92 centrally located within an opening 94 defined by the generally annular shaped ring 90. As illustrated, the exemplary single layered multi-piece baffle plate 54 comprises a hexagonally shaped opening 94 and a hexagonally shaped insert portion 92. In this embodiment, the hexagonal shape was chosen to accommodate a desired flow pattern for a particular plasma ashing application. As previously described, the annular ring as well as the number of pieces forming the single layered baffle plate assembly can define any opening shape. Again, although applicant refers to an annular ring, it is contemplated that the various pieces do not include an annular ring. Rather, the multiple pieces are configured and constructed so as to form a single layer of the baffle plate. A locking means would be included to maintain the baffle plate in a generally planar configuration and is well within the skill of those in the art.

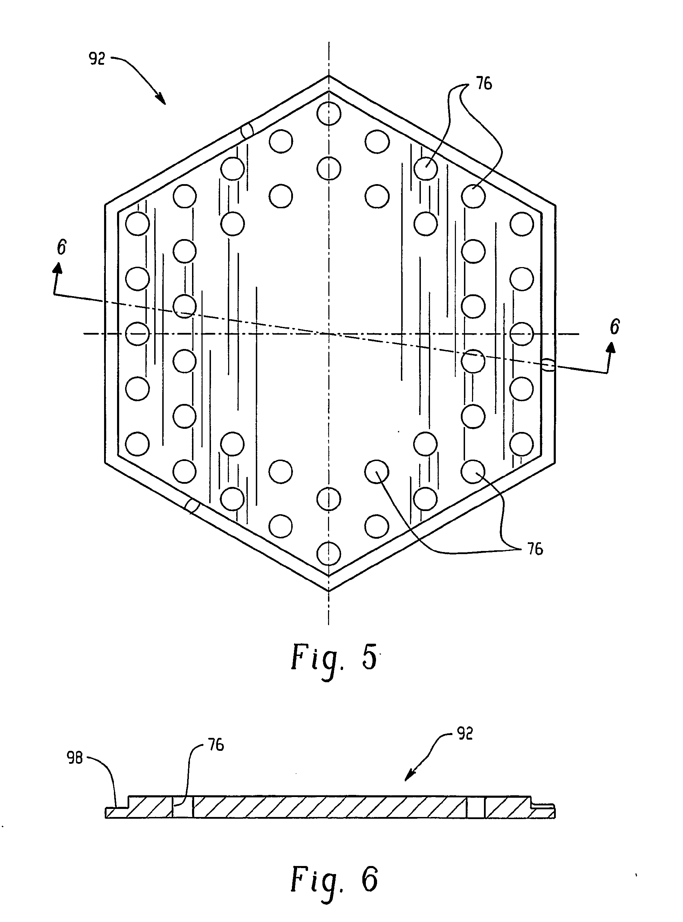

Figure 4 illustrates a cross sectional view of the single layered multi-piece baffle plate assembly 54. The opening 94 of the annular shaped ring 90 includes a recessed portion 96 dimensioned to receive a shoulder portion 98 formed about an outer edge of the insert portion 92 (shown more clearly in Figure 6). Optionally, three or more support pins 100 are radially disposed in the shoulder 98 at equidistant positions about the annular recessed portion to minimize scraping (and possible particle generation) between the insert portion and the annular shaped ring. A gap formed between the insert portion 92 and the annular shaped ring 90 is less than about 0.010 inches to allow radial expansion during plasma operation and provide a net surface that is wetted by the plasma as if the baffle plate were formed a single unitary piece. Figures 5 and 6 depict the insert portion 92. As shown, the insert portion 92 includes a non-apertured central portion.

The so-formed single layered multi-piece baffle plate generally includes a plurality of apertures, wherein the apertures are arranged in a radial (or concentric multiply circular) pattern. The single layered multi-piece baffle plate may or may not include a non-apertured central portion as may be desired for certain plasma applications. The design of the baffle plate assembly (single or dual layered) is generally determined by applied gas dynamics, materials engineering, and process data to insure correct pressure, gas flows, and temperature gradients within the process chamber.

In the case of a dual layered multi-piece baffle plate assembly, the upper baffle plate and/or the lower baffle plate can be comprised of multiple pieces in the manner previously described. For example, the upper baffle plate can be formed of multiple pieces, wherein the lower baffle plate is formed of a single unitary piece. In the dual layered configuration, the apertures in the upper baffle plate are slightly larger than the apertures in the lower baffle plate. Moreover, it may be preferred to have a central non-apertured portion within the upper baffle plate. In this manner, the non-apertured portion diverts the energized gases from the plasma tube radially outward to the remaining apertured area of the upper baffle plate so as to prevent the radially inward portion of the wafer being preferentially processed before the outward portion of the wafer. The distance between the upper and lower baffle plates, in part, determines the pattern of gas flow through the dual layered baffle plate assembly. Apertures are provided in the radially inner portion of the lower baffle plate but generally not in the radial external portion. The surface area of the radially inner portion of the lower baffle plate is sufficient to cover the wafer residing therein below. In one embodiment, the apertures are generally positioned equidistant from each other in all directions. That is, any three apertures that are mutually immediately adjacent to each other form an equilateral triangle. Other distributions of holes on the baffle plates may also be of use for specific applications such as, for example, larger holes on the outer diameters but smaller holes on the inside diameters so as to improve ash unifonnity. Moreover, it is noted that the dual layered baffle plate assembly is generally compact, requiring less than one-inch vertical space within the process chamber.

The upper multi-piece baffle plate is preferably formed from a ceramic material. Suitable ceramic materials include, but are note intended to be limited to, alumina (various aluminum oxides), zirconium dioxides, various carbides such as silicon carbide, boron carbide, various nitrides such as silicon nitride, aluminum nitride, boron nitride, quartz, silicon dioxides, various oxynitrides such as silicon oxynitride, and the like as well as stabilized ceramics with elements such as magnesium, yttrium, praseodymia, hafnium, and the like. Optionally, the lower single piece baffle plate can be the same or of a different material, typically anodized aluminum.

The disclosure is further illustrated by the following non-limiting examples.

### Examples

In the following examples, a plasma asher was configured with a dual layered multi-piece baffle plate assembly and separately with a conventional dual layered baffle plate assembly. Typical data were acquired and analyzed, comparing the two configurations. The upper baffle plate of the dual layered multi-piece baffle plate assembly was of a two-piece construction similar to that shown in Figures 3-6 and formed from high purity alumina. The baffle plate assemblies for the two configurations were identical with the exception of the multi-piece construction of the upper baffle plate in the dual layered multi-piece baffle plate assembly. The baffle plate assemblies were subjected to a low temperature plasma ashing process (120°C) and a high temperature plasma ashing process (270oC). Gas flow, pressure and microwave power were identical. The results are shown in Tables 1 and 2, respectively. Ashing rate and plasma uniformity were compared for the two baffle plate assemblies.

**Table 1.**

| Baffle Plate Type | Ash Rate (µm/min) | Standard Deviation (µm/min) | % Non-uniformity (1σ) | Standard Deviation (1σ) |
|---|---|---|---|---|
| Control | 0.13 | 0.002 | 8.71 | 0.012 |
| Multi-piece Ceramic | 0.12 | 0.001 | 11.14 | 0.209 |

**Table 2**

| Baffle Plate Type | Ash Rate (µm/min) | Standard Deviation (µm/min) | % Non-uniformity (1σ) | Standard Deviation (1σ) |
|---|---|---|---|---|
| Control | 7.75 | 0.10 | 4.1 | 0.26 |
| Multi-piece Ceramic | 7.27 | 0.02 | 4.75 | 0.16 |

The results indicate that the use of the multi-piece construction provided similar ashing behavior.

In this example, the generation of particle adders greater than 0.12 nanometers that were deposited onto the wafer during plasma ashing was monitored. The results are shown in Table 3.

**Table 3.**

| Baffle Plate Type | Ash Rate (µm/min) | Standard Deviation (1σ) |
|---|---|---|
| Control | 53 | 16.82 |
| Multi-piece Ceramic | 87 | 10.02 |

The results show that the use of the ceramic multi-piece did not contribute significantly to particle adder generation.

In this example, time to end point was monitored for a plasma ashing process. Photoresist was coated onto 300 millimeter wafers at a thickness of 1.0 micron. The results are shown in Table 4.

**Table 4.**

| Baffle Plate | Time to Endpoint (Seconds) | Standard Deviation |
|---|---|---|
| Control | 10.43 | 0.41633 |
| Multi-piece Ceramic | 11.80 | 0.1000 |

The results show that the time for ashing the photoresist was not significantly different for the plasma asher configured with the multi-piece ceramic baffle plate assembly as described.

While the disclosure has been described with reference to an exemplary embodiment, it will be understood by those skilled in the art that various changes may be made and equivalents may be substituted for elements thereof without departing from the scope of the disclosure. In addition, many modifications may be made to adapt a particular situation or material to the teachings of the disclosure without departing from the essential scope thereof. Therefore, it is intended that the disclosure not be limited to the particular embodiment disclosed as the best mode contemplated for carrying out this disclosure, but that the disclosure will include all embodiments falling within the scope of the appended claims.

## Claims

1. A ceramic baffle plate assembly for distributing plasma into a process chamber (16) containing a semiconductor wafer (18) to be processed, the ceramic baffle plate assembly comprising:
a generally planar multi-piece baffle plate (54) that can be spaced apart from and fixedly positioned above the semiconductor wafer to be processed, wherein the generally planar multi-piece baffle plate (54) comprises at least one annular shaped ring portion (90) defining a central through hole opening and an insert portion (92) dimensioned to sit within the central through hole opening, wherein the annular shaped ring portion (90) and the insert portion (92) are configured so as to form a single layer of the generally planar multi-piece baffle plate (54), and being **characterised in that** a gap of less than 0.25mm (0.010 inches) is provided between the insert portion (92) and the annular shaped ring portion (90).

2. The ceramic baffle plate assembly of claim 1, wherein the opening (94) comprises an annular recessed portion and the insert portion comprises a lip adapted to seat on the annular recessed portion (96).

3. The ceramic baffle plate assembly of claim 2, wherein the annular recessed portion (96) further comprises at least three pins (100) spaced equidistantly about the annular recessed portion (96), wherein the insert portion (92) is supported by the at least three pins (100).

4. The ceramic baffle plate assembly of claim 1, wherein the multi-piece baffle plate (54) comprises a non-apertured central portion.

5. The ceramic baffle plate assembly of claim 1, wherein the baffle plate assembly comprises an upper baffle plate and a lower baffle plate, wherein the upper baffle plate comprises the multi-piece baffle plate (54), wherein the multi-piece baffle plate has a non-apertured central portion.

6. A plasma processing chamber (16) for processing a semiconductor wafer, comprising:
a wafer processing cavity into which a wafer (18) may be inserted for processing, the wafer processing cavity defined in part by walls including a top wall; and
a baffle plate assembly located adjacent said wafer processing cavity for distributing energized gas thereinto, said baffle plate assembly comprising a ceramic baffle plate assembly as claimed in any of claims 1 to 5 fixedly positioned above a generally planar lower baffle plate.

7. The plasma processing chamber of claim 6, wherein the chamber (16) is adapted to receive a wafer (18) having a diameter of at least 200 millimetres.

8. A downstream plasma treatment device for treating a substrate, comprising, in combination:
a gas source (12);
a plasma generating component (32) in fluid communication with the gas source (12), the plasma generating component comprising a plasma tube (32) and a plasma generator coupled to the plasma tube for generating a plasma within the plasma tube from the gas source; and
a plasma processing chamber according to either claim 6 or 7, in fluid communication with the plasma tube.

9. A method for preventing cracking of a ceramic baffle plate having a radius greater than 100mm (4 inches) during a plasma mediated process, wherein the plasma mediated process subjects the ceramic baffle plate to a thermal temperature gradient across the plate, the method comprising:
forming the ceramic baffle plate into at least two pieces, wherein the at least two pieces comprise at least one annular shaped ring portion (90) having a central through hole opening (94) and an insert portion (92) dimensioned to sit within the central through hole opening (94), such that the annular shaped ring portion (90) and the insert portion (92) form a single layer of the ceramic baffle plate, and such that a gap formed between the insert portion (92) and the annular shaped ring portion (90) that is less than 0.25mm (0.010 inches) ;
and
exposing the at least two pieces of the ceramic baffle plate to plasma formed during the plasma mediated process,

10. The method of claim 9, wherein exposing the at least two pieces of the ceramic baffle plate to plasma subjects the at least two pieces to hoop stresses less than a material stress for the ceramic.

## Patentansprüche

1. Keramische Prallplattenbaugruppe zum Verteilen von Plasma in eine Prozesskammer (16) hinein, die einen zu verarbeitenden Halbleiterwafer (18) enthält, wobei die keramische Prallplattenbaugruppe Folgendes enthält:
eine allgemein planare mehrteilige Prallplatte (54), die von dem zu verarbeitenden Halbleiterwafer beabstandet und fest über diesem positioniert sein kann, wobei die allgemein planare mehrteilige Prallplatte (54) mindestens einen kreisförmigen Ringabschnitt (90), der eine mittige Durchgangslochöffnung definiert, und einen Einsatzabschnitt (92), der dafür bemessen ist, in der mittigen Durchgangslochöffnung zu sitzen, umfasst, wobei der kreisförmige Ringabschnitt (90) und der Einsatzabschnitt (92) so konfiguriert sind, dass sie eine einzelne Schicht der allgemein planaren mehrteiligen Prallplatte bilden, und **dadurch gekennzeichnet sind, dass** ein Spalt von weniger als 0,25 mm (0,010 Inch) zwischen dem Einsatzabschnitt (92) und dem kreisförmigen Ringabschnitt (90) vorhanden ist.

2. Keramische Prallplattenbaugruppe nach Anspruch 1, wobei die Öffnung (94) einen ringförmigen Aussparungsabschnitt umfasst und der Einsatzabschnitt eine Lippe umfasst, die dafür ausgelegt ist, auf dem ringförmigen Aussparungsabschnitt (96) zu sitzen.

3. Keramische Prallplattenbaugruppe nach Anspruch 2, wobei der ringförmige Aussparungsabschnitt (96) des Weiteren mindestens drei Stifte (100) umfasst, die gleichmäßig um den ringförmigen Aussparungsabschnitt (96) herum angeordnet sind, wobei der Einsatzabschnitt (92) durch die mindestens drei Stifte (100) gestützt wird.

4. Keramische Prallplattenbaugruppe nach Anspruch 1, wobei die mehrteilige Prallplatte (54) einen keine Öffnungen enthaltenden mittigen Abschnitt umfasst.

5. Keramische Prallplattenbaugruppe nach Anspruch 1, wobei die Prallplattenbaugruppe eine obere Prallplatte und eine untere Prallplatte umfasst, wobei die obere Prallplatte die mehrteilige Prallplatte (54) umfasst, wobei die mehrteilige Prallplatte einen keine Öffnungen enthaltenden mittigen Abschnitt umfasst.

6. Plasmaverarbeitungskammer (16) zur Verarbeitung eines Halbleiterwafers, die Folgendes umfasst:
einen Waferverarbeitungshohlraum, in den ein Wafer (18) zum Verarbeiten eingelegt werden kann, wobei der waferverarbeitungshohlraum teilweise durch Wände, einschließlich einer oberen Wand, definiert wird; und
eine neben dem Waferverarbeitungshohlraum angeordnete Prallplattenbaugruppe zum Verteilen von mit Energie beaufschlagtem Gas in den Waferverarbeitungshohlraum hinein, wobei die Prallplattenbaugruppe eine keramische Prallplattenbaugruppe nach einem der Ansprüche 1 bis 5 umfasst, die fest über einer allgemein planaren unteren Prallplatte positioniert ist.

7. Plasmaverarbeitungskammer nach Anspruch 6, wobei die Kammer (16) dafür ausgelegt ist, einen Wafer (18) mit einem Durchmesser von mindestens 200 Millimetern aufzunehmen.

8. Nachgeschaltete Plasmabehandlungsvorrichtung zum Behandeln eines Substrats, die in Kombination Folgendes umfasst:
eine Gasquelle (12);
eine Plasmaerzeugungskomponente (32) in Strömungsverbindung mit der Gasquelle (12), wobei die Plasmaerzeugungskomponente eine Plasmaröhre (32) und einen Plasmagenerator umfasst, der mit der Plasmaröhre gekoppelt ist, um ein Plasma innerhalb der Plasmaröhre aus der Gasquelle zu erzeugen; und
eine Plasmaverarbeitungskammer nach einem der Ansprüche 6 oder 7, die in Strömungsverbindung mit der Plasmaröhre steht.

9. Verfahren zum Verhindern des Reißens einer keramischen Prallplatte mit einem Radius von mehr als 100 mm (4 Inch) während eines plasmavermittelten Prozesses, wobei der plasmavermittelte Prozess die keramische Prallplatte einem über die gesamte Platte hinweg verlaufenden thermischen Temperaturgradienten aussetzt, wobei das Verfahren Folgendes umfasst:
Teilen der keramischen Prallplatte in mindestens zwei Teile, wobei die mindestens zwei Teile mindestens einen kreisförmigen Ringabschnitt (90), der eine mittige Durchgangslochöffnung (94) definiert, und einen Einsatzabschnitt (92), der dafür bemessen ist, in der mittigen Durchgangslochöffnung (94) zu sitzen, umfassen, dergestalt, dass der kreisförmige Ringabschnitt (90) und der Einsatzabschnitt (92) eine einzelne Schicht der keramischen Prallplatte bilden, und dergestalt, dass ein Spalt, der zwischen dem Einsatzabschnitt (92) und dem kreisförmigen Ringabschnitt (90) gebildet wird, weniger als 0,25 mm (0,010 Inch) misst, und
Inkontaktbringen der mindestens zwei Teile der keramischen Prallplatte mit Plasma, das während des plasmavermittelten Prozesses erzeugt wird.

10. Verfahren nach Anspruch 9, wobei durch das Inkontaktbringen der mindestens zwei Teile der keramischen Prallplatte mit Plasma in den mindestens zwei Teilen Ringzugspannungen entstehen, die geringer sind als eine Materialspannung für die Keramik.

## Revendications

1. Ensemble de chicane en céramique pour distribuer du plasma dans une chambre de traitement (16) contenant une tranche à semi-conducteur (18) à traiter, l'ensemble de chicane en céramique comprenant ;
une chicane multipièce généralement plane (54) qui peut être espacée et positionnée fixement au-dessus de la tranche à semi-conducteur à traiter, où la chicane multipièce généralement plane (54) comprend au moins une partie de bague de forme annulaire (90) définissant une couverture de trou traversant centrale et une partie d'insert (92) dimensionnée pour s'asseoir dans l'ouverture de trou traversant centrale, où la partie de bague de forme annulaire (90) et la partie d'insert (92) sont configurées pour former une seule couche de la chicane multipièce généralement plane (54), et étant **caractérisé en ce qu'**un écartement de moins de 0,25 mm (0,010 pouce) est prévu entre la partie d'insert (92) et la partie de bague de forme annulaire (90).

2. Ensemble de chicane en céramique selon la revendication 1, dans lequel l'ouverture (94) comprend une partie évidée annulaire et la partie d'insert comprend une lèvre adaptée pour s'asseoir sur la partie évidée annulaire (96).

3. Ensemble de chicane en céramique selon la revendication 2, dans lequel la partie évidée annulaire (96) comprend en outre au moins trois broches (100) à équidistance autour de la partie évidée annulaire (96), où la partie d'insert (92) est supportée par au moins trois broches (100).

4. Ensemble de chicane en céramique selon la revendication 1, dans lequel la chicane multipièce (54) comprend une partie centrale sans ouverture.

5. Ensemble de chicane en céramique selon la revendication 1, dans lequel l'ensemble de chicane comprend une chicane supérieure et une chicane inférieure, où la chicane supérieure comprend la chicane multipièce (54), où la chicane multipièce comporte une partie centrale sans ouverture.

6. Chambre de traitement au plasma (16) pour traiter une tranche à semi-conducteur comprenant :
✔ une cavité de traitement de tranche dans laquelle une tranche (18) peut être insérée pour traitement, la cavité de traitement de tranche étant définie en partie par des parois incluant une paroi supérieure ; et
✔ un ensemble de chicane adjacent à ladite cavité de traitement de tranche, pour y distribuer un gaz alimenté en énergie, ledit ensemble de chicane comprenant un ensemble de chicane en céramique tel que revendiqué dans l'une quelconque des revendications 1 à 5 fixement positionné au-dessus d'une chicane inférieure généralement plane.

7. Chambre de traitement au plasma selon la revendication 6, dans laquelle la chambre (16) est adaptée pour recevoir une tranche (18) ayant un diamètre d'au moins 200 millimètres.

8. Dispositif de traitement au plasma aval pour traiter un substrat, comprenant, en combinaison :
✔ une source de gaz (12) ;
✔ un composant de génération de plasma (32) en communication fluidique avec la source de gaz (12), le composant de génération de plasma comprenant un tube plasma (32) et un générateur de plasma couplé au tube plasma pour générer un plasma dans le tube plasma à partir de la source de gaz ; et
✔ une chambre de traitement au plasma selon la revendication 6 ou 7, en communication fluidique avec le tube plasma.

9. Procédé pour empêcher la fissuration d'une chicane en céramique ayant un rayon plus grand que 100 mm (4 pouces) pendant un procédé au plasma, où le procédé au plasma soumet la chicane en céramique à un gradient de température thermique à travers la chicane, le procédé comprenant les étapes consistant à :
✔ former la chicane en céramique en au moins deux pièces, où les au moins deux pièces comprennent au moins une partie de bague de forme annulaire (90) comportant une ouverture de trou traversant centrale (94) et une partie d'insert (92) dimensionnée pour s'asseoir dans l'ouverture de trou traversant centrale (94), de telle sorte que la partie de bague de forme annulaire (90) et la partie d'insert (92) forment une seule couche de la chicane en céramique, et de telle sorte qu'un écartement formé entre la partie d'insert (92) et la partie de bague de forme annulaire (90) est inférieur à 0,25 mm (0,010 ponce) ; et
✔ exposer les au moins deux pièces de la chicane en céramique à un plasma formé pendant le procédé au plasma.

10. Procédé selon la revendication 9, dans lequel l'exposition des au moins deux pièces de la chicane en céramique au plasma soumet les au moins deux pièces à des tensions de charge inférieures à une contrainte de matériau pour la céramique.
